(19) Europäisches Patentamt
European Patent Office
Office européen des brevets

(11) Numéro de publication: **0 327 475**
**A1**

## (12) DEMANDE DE BREVET EUROPEEN

(21) Numéro de dépôt: **89420027.8**

(22) Date de dépôt: **01.02.89**

(51) Int. Cl.⁴: **H 01 L 27/02**
**H 02 H 9/04**

(30) Priorité: **04.02.88 FR 8801551**

(43) Date de publication de la demande:
**09.08.89 Bulletin 89/32**

(84) Etats contractants désignés: **DE FR GB IT NL**

(71) Demandeur: **SGS-THOMSON MICROELECTRONICS S.A.**
**7, Avenue Galliéni**
**F-94250 Gentilly (FR)**

(72) Inventeur: **Marquot, Alexis**
**Quartier Belle Vue Pourrières**
**F-83470 Saint Maximin (FR)**

**Tailliet, François**
**49, Avenue Gabriel Péri**
**F-93800 Epinay/sur Seine (FR)**

(74) Mandataire: **de Beaumont, Michel**
**1bis, rue Champollion**
**F-38000 Grenoble (FR)**

(54) Structure de protection des sorties d'un circuit intégré de type MOS.

(57) La présente invention concerne une structure de protection contre des surtensions d'un amplificateur de sortie d'un circuit intégré de type MOS, dans laquelle un dispositif à conduction bidirectionnelle (30) est connecté entre un plot (31) relié au drain ou à la source du transistor MOS à protéger et une tension de référence, et une résistance (56) est connectée entre le dispositif à claquage bidirectionnel et le transistor MOS à protéger, la valeur de la résistance étant choisie pour que le produit de cette valeur par un courant inférieur au courant maximal admissible dans le drain/source du transistor à protéger soit légèrement supérieur à la différence entre la tension de claquage du dispositif de protection et la tension à la conduction sur le drain/source du transistor MOS.

Figure 6

EP 0 327 475 A1

Description

## STRUCTURE DE PROTECTION DES SORTIES D'UN CIRCUIT INTÉGRÉ DE TYPE MOS

La présente invention concerne des structures de protection contre des surtensions de circuits intégrés et plus particulièrement la protection des amplificateurs de sortie d'un circuit intégré de type MOS.

Un circuit intégré comprend des plots d'entrée et des plots de sortie. Des surtensions appliquées sur ces plots peuvent entraîner la destruction du circuit. Un plot d'entrée est généralement connecté à au moins une grille de transistor MOS, et un plot de sortie à au moins un drain - ou une source - de transistor MOS. La grille d'un transistor MOS étant un élément particulièrement fragile, elle constitue l'élément principalement affecté lors de l'application de surtensions. L'effort sur la protection contre les surtensions s'est donc porté dans un premier temps sur la protection des grilles d'entrée du circuit. Actuellement les protections de grilles d'entrée ont fait de tels progrès que les drains/sources de sortie des circuits deviennent le point critique. Il est donc indispensable de prévoir des structures de protection de drains/sources de sortie de circuits.

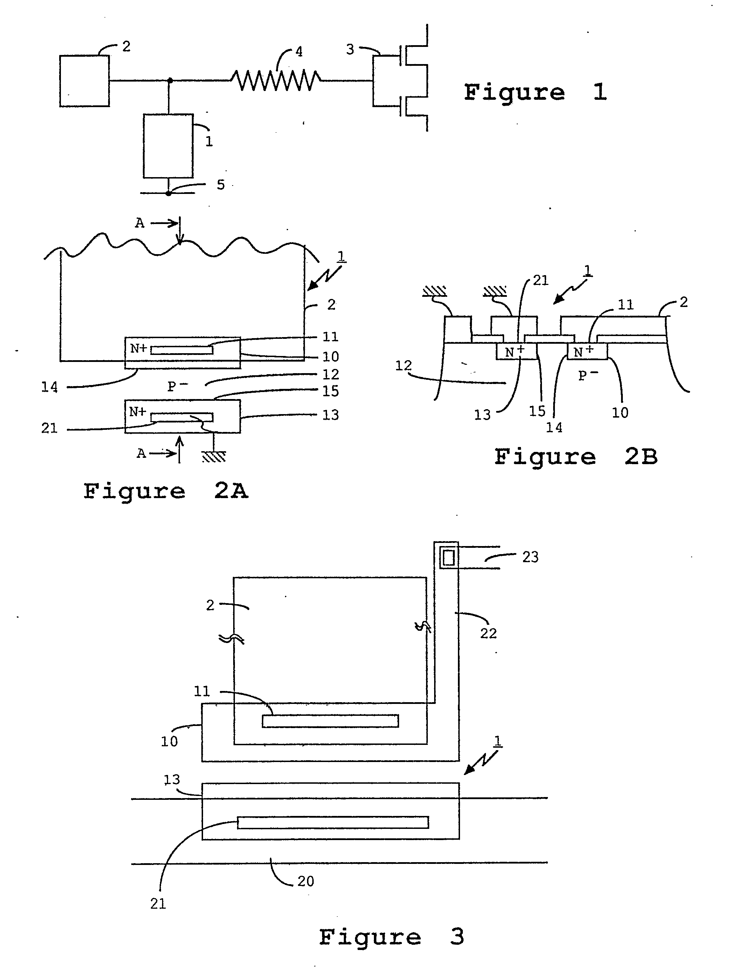

La figure 1 représente un exemple de montage de protection d'entrée classique d'un circuit MOS. Un dispositif à conduc tion bidirectionnelle 1 est connecté entre un plot d'entrée 2, relié à des grilles d'entrée 3 du circuit à protéger, et une tension de référence 5, couramment la masse. Une résistance 4 est connectée entre le dispositif à conduction bidirectionnelle 1 et les grilles d'entrée 3 du circuit. Lorsqu'une surtension est appliquée au plot d'entrée 2, le dispositif à conduction bidirectionnelle 1 est mis en mode de conduction comme cela sera décrit en relation avec la figure 2. La surtension est ainsi absorbée par le dispositif à conduction bidirectionnelle, claquage, et la résistance permet de faire chuter la tension à une valeur non destructrice pour le circuit.

La figure 2A représente en vue de dessus un exemple de dispostif à conduction bidirectionnelle classique et la figure 2B représente une vue en coupe selon AA du dispositif représenté sur la figure 2A. C'est un dispositif de type N$^+$P$^-$N$^+$, comprenant une première région 10 de type N$^+$ reliée au plot d'entrée 2 par un contact 11, la partie P$^-$ étant constituée par le substrat 12 et une autre région 13 de type N$^+$ étant connectée à la tension de référence par un contact 21.

Si une surtension négative est appliquée au plot 2, la première jonction NP 14 formée de la région 10 de type N$^+$ et de la partie P$^-$ constituée par le substrat 12 relié à la masse se trouve en polarisation directe et la surtension sera absorbée par la connexion de masse du substrat.

Si une surtension positive est appliquée au plot 2, la première jonction PN 14 est polarisée en inverse. Elle passe en avalanche pour une surtension supérieure à une valeur V$_Z$ (environ 20 volts) et le courant commence à être évacué par la connexion de masse du substrat. Etant donné que le substrat est très résistif, son potentiel croît au niveau de la second région de type N$^+$ 13. Dès que le potentiel du substrat dépasse 0,6 V, la seconde jonction PN 15 formée de la partie P$^-$ constituée par le substrat 12 et de la région 13 de type N$^+$ se trouve en polarisation directe. La surtension sera alors absorbée par l'avalanche de la structure P$^+$N$^-$P$^+$.

La figure 3 représente un exemple de montage de protection d'entrée classique en vue de dessus sur la plaquette qui supporte le circuit intégré à protéger. Un dispositif à conduction bidirectionnelle 1 du type de celui représenté sur les figures 2A et 2B est connecté d'une part à un plot d'entrée 2 du circuit par un contact 11 de d'autre part à une métallisation 20, se trouvant à la tension de référence, par un contact 21. La région 10 de type N$^+$ de ce dispositif qui est connectée au plot comprend un prolongement 22 de longueur importante devant sa largeur, cette longueur s'étendant dans une direction qui s'éloigne du dispositif P$^+$N$^-$P$^+$. Ce prolongement constitue une résistance dont l'autre extrémité est connectée par une métallisation 23 à au moins une grille d'entrée du circuit (non représentée sur la figure). La valeur de la résistance doit permettre de faire chuter la tension qui apparaît lors de l'apparition d'une impulsion de surtension sur le plot 2, à une valeur non destructive pour le circuit. Chaque élément de surface entre le prolongement N$^+$ et le substrat P$^-$ constitue une diode Zener élémentaire. L'interface totale entre la résistance et le substrat correspond à une diode Zener répartie. La tension dans le substrat lors de l'impulsion, également importante au voisinage du plot à cause de la valeur assez forte de la résistance de la partie P$^-$ constituée par le substrat 12 et du courant assez important pouvant passer entre la région 10 et la partie P$^-$, décroît progressivement quand on s'éloigne du plot le long de la résistance et atteint une valeur voisine de 0 V à l'extrémité du prolongement opposée au plot.

Divers articles ont traité des plots de sortie d'un circuit intégré. Dans l'article de R. Marchandeau, R. N. Rountree et C. Duvvury, "Improvements of ESD Protection in Semiconductor Devices", il est indiqué que les dispositifs de sortie sont susceptibles de s'autoprotéger de par leur taille importante.

Par ailleurs, les ouvrages "CMOS Analog Circuit Design", par P. E. Allen et D. R. Holberf, éditions Holt, Rinehart and Winston, en page 299, et "The Design and Analysis of VLSI Circuits" par L. A. Glasser et D. W. Dobberpuhl, en page 320, montrent la nécessité de minimiser la résistance de sortie. Il apparaît ainsi comme un inconvénient d'utiliser pour la protection des sorties des circuits intégrés une structure du type de celle employée pour la protection des entrées, à cause notamment d'une résistance trop importante.

Ainsi, un object de la présente invention est de prévoir un mode de protection d'une borne de sortie de circuit intégré MOS ne nuisant pas au fonctionnement du circuit.

Ces objets ainsi que d'autres de la présente invention sont atteints en prévoyant une structure de protection contre des surtensions des amplificateurs de sortie d'un circuit intégré de type MOS, dans laquelle un dispositif à claquage bidirectionnel est connecté entre un plot relié au drain ou à la source du transistor MOS à protéger et une tension de référence, et une résistance est connectée entre le dispositif à claquage bidirectionnel et le transistor MOS à protéger, la valeur de la résistance étant choisie pour que le produit de cette valeur par un courant inférieur au courant maximal admissible dans le drain/source du transistor à protéger soit légèrement supérieur à la différence entre la tension de claquage du dispositif de protection et la tension à la conduction sur le drain/source du transistor MOS.

Ces objets, caractéristiques et avantages ainsi que d'autres de la présente invention seront exposés plus en détail dans la description suivante d'un mode de réalisation particulier faite en relation avec les figures jointes parmi lesquelles :

La figure 1, décrite précédemment, représente un montage de protection d'entrée d'un circuit MOS selon l'art antérieur ;

les figures 2A et 2B, décrites précédemment, représentent en vue de dessus et en coupe un dispositif à conduction bidirectionnelle selon l'art antérieur ;

la figure 3, décrite précédemment, représente en vue de dessus un montage de protection d'entrée selon l'art antérieur ;

la figure 4 représente un structure de protection de sortie d'un circuit MOS ;

la figure 5 représente un diagramme d'évolution de tension en fonction du temps correspondant à la structure de la figure 4 ;

la figure 6 représente en vue de dessus une structure de protection de sortie d'un circuit MOS selon la présente invention ; et

les figures 7A et 7B représentent des diagrammes d'évolution de tension en fonction du temps correspondant à la structure de la figure 6.

De façon générale, et comme cela est classique dans la représentation des circuits intégrés, on notera que les diverses figures ne sont pas représentées à l'échelle ni d'une figure à l'autre, ni à l'intérieur d'une même figure, et notamment que les dimensions des couches sont dessinées arbitrairement dans le but de faciliter la lecture des figures.

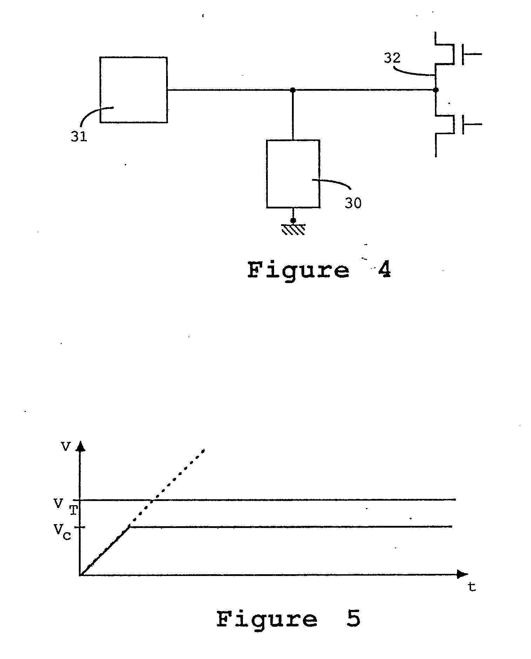

La figure 4 représente un type de structure de protection de sortie d'un circuit MOS que l'on pourrait penser à adopter à la lecture des documents de l'art antérieur, à savoir un dispositif à conduction bidirectionnelle sans résistance série entre le plot et le dispositif à protéger. Un dispositif à conduction bidirectionnelle 30 est connecté entre un plot de sortie 31, relié à des drains/source de sortie 32 du circuit à protéger, et une tension de référence, couramment la masse.

La figure 5 représente sur le même diagramme, dans le cas où une impulsion est appliquée au plot 31 de la structure représentée sur la figure 4, d'une part, la tension de l'impulsion, en pointillés, qui croît rapidement avec le temps, d'autre part, la tension aux drains/sources qui augmente simultanément et se stabilise lorsque la valeur de la tension à la conduction $V_c$ du transistor MOS est atteinte. La tension $V_T$ est la tension de claquage du dispositif de protection. Les technologies courantes de fabrication entraînent que la tension $V_T$ est supérieure à la tension $V_c$ si l'on ne veut pas recourir à des procédés complexes. Ainsi, lors de l'impulsion, le transistor sera mis en mode de conduction et laissera passer un courant destructif avant que le dispositif à conduction bidirectionnelle ne se déclenche.

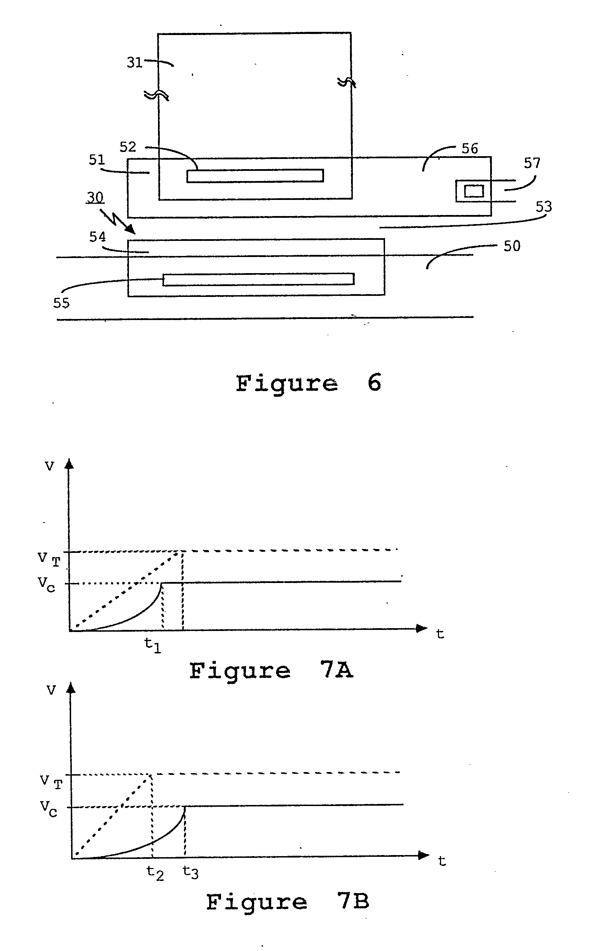

La figure 6 représente une vue de dessus d'un mode de réalisation d'une structure de protection de sortie selon la présente invention. Un dispositif à conduction bidirectionnelle, semblable à celui représenté sur la figure 2, est connecté entre le plot 31 et une métallisation 50 reliée à la tension de référence. Ce dispositif à conduction bidirectionnelle est constitué d'une première région 51 de type N$^+$, qui est connectée par un contact 52 au plot 31, d'une partie P$^-$, qui est le substrat 53, et d'une seconde région 54 de type N$^+$ connectée par un contact 55 à la métallisation 50 (la masse).

La région 51 de type N$^+$ comprend un prolongement 56 de faible longueur. Ce prolongement constitue une résistance dont l'autre extrémité est connectée par une métallisation 57 aux drains/sources du circuit à protéger (non représenté sur la figure).

Les figures 7A et 7B représentent pour deux cas particuliers l'évolution des tensions au début de l'application d'une tension sur le plot. La tension sur le plot est illustrée en pointillés et la tension sur le drain à protéger est représentée en trait plein.

Dans le cas de la figure 7A, les constantes de temps sont telles que, lorsqu'une surtension est appliquée, le transistor MOS conduit d'abord dès l'instant où la tension atteint la valeur $V_c$ ; puis le courant augmente, du fait de la chute de tension dans la résistance constituée par le prolongement 56, la tension sur la région 51 du type N$^+$ devient supérieure à la tension de claquage $V_T$ du dispositif de protection. La valeur de la résistance du prolongement 56 est choisie de sorte que le produit de cette valeur par un courant inférieur au courant maximum admissible dans les drains/sources des transistors à protéger soit légèrement supérieur à la différence entre la tension de claquage $V_T$ du dispositif de protection et la tension à la conduction $V_c$ sur les drains/sources des transistors. En pratique, avec les technologies habituelles de dopage des régions N$^+$, cette résistance présentera en vue de dessus une surface correspondant à un à deux carrés, c'est-à-dire une valeur bien inférieure à celle du prolongement 22 de la figure 2.

Dans le cas de la figure 7B, les constantes de temps du circuit (capacité parasite associée à la résistance 56) sont telles que la tension $V_T$ est atteinte sur le plot, avant que la tension sur le drain atteigne la valeur $V_C$. A l'instant $t_3$, du courant passera dans le transistor si l'impulsion n'a pas déjà été absorbée par la protection, mais, en raison du choix susmentionné de la valeur de la résistance 56, ce courant dans le drain ne sera pas destructif.

On voit qu'ici la résistance 56 a une fonction différente de celle de la résistance 22 des circuits connus de protection de grille. En effet, dans le cas des circuits de protection de grille, on cherchait à éviter toute conduction des grilles. Selon l'invention, pour la protection de drains ou de sources, on cherche seulement à limiter le courant de claquage ce qui permet de choisir des résistances de valeurs non nulles mais très faibles ne faisant pas obstacle au bon fonctionnement normal des étages de sortie.

**Revendications**

1. Structure de protection contre des surtensions d'un amplificateur de sortie d'un circuit intégré de type MOS, dans laquelle un dispositif à claquage bidirectionnel (30) est connecté entre un plot (31) relié au drain ou à la source du transistor MOS à protéger et une tension de référence, et une résistance (56) est connectée entre le dispositif à claquage bidirectionnel et le transistor MOS à protéger, caractérisée en ce que la valeur de la résistance est choisie pour que le produit de cette valeur par un courant inférieur au courant maximal admissible dans le drain/source du transistor à protéger soit légèrement supérieur à la différence entre la tension de claquage ($V_T$) du dispositif de protection et la tension à la conduction ($V_c$) sur le drain/source du transistor MOS.

2. Structure de protection selon la revendication 1, dans laquelle le circuit intégré est réalisé sur un substrat (53) d'un premier type de conductivité et dans laquelle le dispositif à conduction bidirectionnelle comprend une première zone (51) du deuxième type de conductivité à fort niveau de dopage reliée par une métallisation au plot (31) en vis à vis d'une autre zone (54) du deuxième type de conductivité à fort niveau de dopage reliée par une métallisation (50) à la masse, caractérisée en ce que la première zone (51) est reliée par une métallisation (57) à la sortie du circuit à protéger par l'intermédiaire d'un prolongement (56) d'une surface de un à deux carrés.

Figure 1

Figure 2A

Figure 2B

Figure 3

Figure 4

Figure 5

Figure 6

Figure 7A

Figure 7B

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | PATENT ABSTRACTS OF JAPAN vol. 10, no. 79 (E-391)(2136), 28 mars 1986; & JP - A - 60 224 259 (HITACHI MAIKURA) 08-11-1985 * le document en entier * | 1,2 | H 01 L 27/02 H 02 H 9/04 |
| A | PATENT ABSTRACTS OF JAPAN vol. 9, no. 159 (E-326)(1882), 4 juillet 1985; & JP - A - 60 038 858 (HITACHI SESAKUSHO) 28-02-1985 * le document en entier * | 1 | |

DOMAINES TECHNIQUES RECHERCHES (Int. Cl.4)

H 01 L
H 02 H

Le présent rapport a été établi pour toutes les revendications

| Lieu de la recherche | Date d'achèvement de la recherche | Examinateur |
|---|---|---|
| BERLIN | 20-04-1989 | LEMMERICH J |